(19) **Europäisches Patentamt European Patent Office Office européen des brevets**

(11) **EP 3 979 505 B1**

(12) **EUROPEAN PATENT SPECIFICATION**

(45) Date of publication and mention of the grant of the patent:
**06.08.2025 Bulletin 2025/32**

(21) Application number: **20826814.4**

(22) Date of filing: **09.06.2020**

(51) International Patent Classification (IPC):
*H03M 13/11* (2006.01)   *H03M 13/37* (2006.01)
*H04L 1/00* (2006.01)   *H04L 1/1867* (2023.01)
*H03M 13/00* (2006.01)

(52) Cooperative Patent Classification (CPC):
**H03M 13/3746; H03M 13/3715; H04L 1/0051; H04L 1/1887; H03M 13/6306**

(86) International application number:
**PCT/CN2020/095100**

(87) International publication number:
**WO 2020/253575 (24.12.2020 Gazette 2020/52)**

(54) **METHOD AND DEVICE FOR DETERMINING NUMBER OF DECODER ITERATIONS, STORAGE MEDIUM, AND ELECTRONIC DEVICE**

VERFAHREN UND VORRICHTUNG ZUR BESTIMMUNG DER ANZAHL VON DECODIERERITERATIONEN, SPEICHERMEDIUM UND ELEKTRONISCHE VORRICHTUNG

PROCÉDÉ ET DISPOSITIF DE DÉTERMINATION DE NOMBRE D'ITÉRATIONS DE DÉCODEUR, SUPPORT DE STOCKAGE ET DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.06.2019   CN 201910537729**

(43) Date of publication of application:
**06.04.2022   Bulletin 2022/14**

(73) Proprietor: **ZTE Corporation**
**Shenzhen, Guangdong 518057 (CN)**

(72) Inventors:
• **WANG, Hongzhan**
  **Shenzhen, Guangdong 518057 (CN)**
• **ZHANG, Wei**
  **Shenzhen, Guangdong 518057 (CN)**
• **ZHANG, He**
  **Shenzhen, Guangdong 518057 (CN)**
• **XU, Chen**
  **Shenzhen, Guangdong 518057 (CN)**
• **ZHOU, Haitao**
  **Shenzhen, Guangdong 518057 (CN)**

(74) Representative: **Canzler & Bergmeier Patentanwälte Partnerschaft mbB Despag-Straße 6 85055 Ingolstadt (DE)**

(56) References cited:
EP-A1- 1 280 280      EP-A1- 2 249 503
WO-A1-2017/151175      CN-A- 103 490 866
CN-A- 105 323 039      CN-A- 106 849 959
CN-A- 109 804 567      CN-B- 102 130 747
US-A1- 2010 241 935    US-A1- 2014 247 909
US-A1- 2014 269 627    US-A1- 2015 244 397
US-B1- 10 020 825      US-B1- 9 966 972

**Description**

**TECHNICAL FIELD**

The present disclosure relates to the field of mobile communications, and in particular, to a method for determining a number of decoder iterations, a storage medium and an electronic device.

**BACKGROUND**

In a mobile communication system, a decoder is configured to perform bit-level processing, such as a decoder of low density parity check code (LDPC) in 5G, a Turbo decoder or convolutional decoder in 4G, and the performance of these decoders is closely related to the number of iterations.

U.S. Patent Application US2014247909A1 discloses a method for making an assumption about how many decoder iterations should be used for different code blocks of the code blocks of the transport block, the assumption is made based on a study of code block soft-bits, and decoding the transport block using different numbers of decoder iterations for the different code blocks, based on the made assumption about how many decoder iterations should be used for the different code blocks.

U.S. Patent Application US2014269627A1 discloses techniques for efficiently decoding data at a receiver. Total available decoding time of the receiver is initially allocated to a plurality of code blocks of a plurality of transport blocks to obtain initial allocated decoding times for the plurality of code blocks being given by a particular number of decoding iterations to perform for that code block. After decoding the one or more code blocks, obtaining updated allocated decoding times for the undecoded code blocks.

E.P. Patent Application EP2249503A1 discloses a decoding apparatus including maximum decoding iteration count controller which determines maximum decoding iteration counts of respective received code words based on modulation schemes and error-correcting coding ratios which are applied to the received code words and average error ratios of the received code words before the code words are decoded, and turbo decoding engine which decodes each of the received code words according to a maximum decoding iteration count determined by maximum decoding iteration count controller.

U.S. Patent Application US10020825B1 discloses a method that enable high performance turbo decoding while keeping the required clock speed and the power consumption low.

**SUMMARY**

The invention is set out in the appended set of claims.

**DESCRIPTION OF DRAWINGS**

The accompanying drawings illustrated herein are used for providing further understanding to the technical solutions of the present disclosure and form a part of the description. The schematic embodiments of the present disclosure and the description thereof are used for explaining the present disclosure, rather than forming improper limitation to the present disclosure. In the accompanying drawings:

Fig. 1 is a schematic diagram of a hardware structure of a base station which executes a method for determining a number of decoder iterations according to an embodiment of the present disclosure;
Fig. 2 is a flowchart illustrating a method for determining a number of decoder iterations according to an embodiment of the present disclosure;
Fig. 3 is a schematic diagram of a device for determining a number of decoder iterations according to the present disclosure;
Fig. 4 is a schematic diagram of an example of a device for determining a number of decoder iterations according to the present disclosure; and
Fig. 5 is a schematic diagram of another example of a device for determining a number of decoder iterations according to the present disclosure.

**DESCRIPTION OF EMBODIMENTS**

The technical solutions of the present disclosure are described in detail below with reference to the accompanying drawings and in combination with the embodiments. It should be noted that the embodiments in the present disclosure and the characteristics in the embodiments may be combined with each other if no conflict is incurred.

It should be noted that the terms "first", "second" and the like in the description and claims of the present disclosure and in the drawings described above are used for distinguishing between similar elements, and not for limiting a particular order or a sequence.

In general, the greater the number of iterations is, the better the performance of the decoder is. However, the capacity of the decoder is fixed under certain conditions, and if a strategy with a fixed number of iterations is used, the capability of the decoder may be wasted, for example, when a capacity of a system is relatively small, the maximum performance of the decoder cannot be exerted; or the number of iterations cannot be configured reasonably at first, too small or too large number of iterations may cause a reduction in capacity of the system or even a crash of the system.

Therefore, in a case where the capacity of the system is variable, it is desirable to find a better method for configuring the number of decoder iterations, so as to utilize the capability of the decoder to the maximum extent and improve the performance index of the mobile communication system.

Embodiments of the present disclosure are directed to at least the problem in existing art that how to configure the number of decoder iterations in the case where the capacity of the system is variable, to provide the technical solutions.

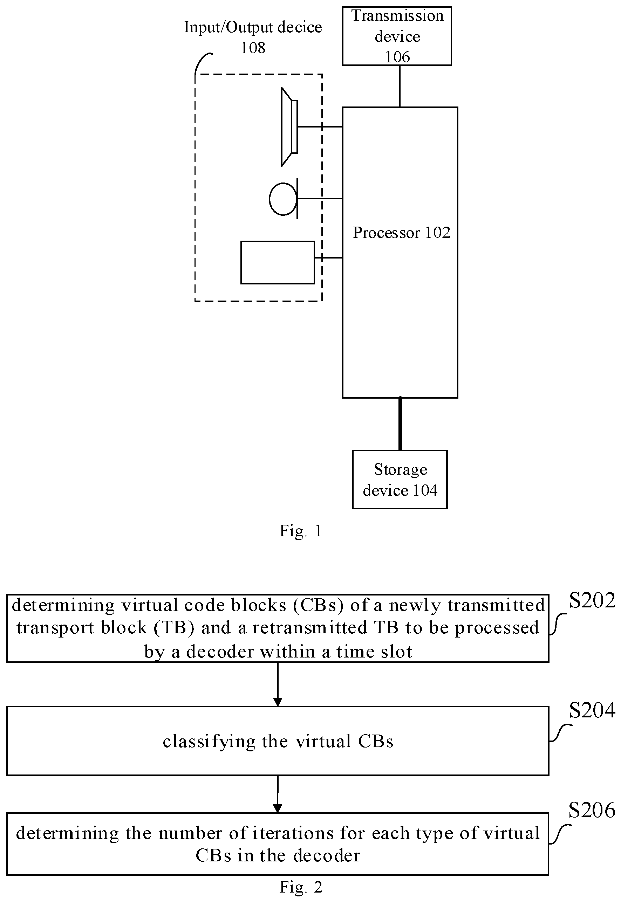

The method provided by the embodiment of the present disclosure may be performed in a base station, a mobile terminal, a computer terminal, or a similar computing device. Taking the method provided by the embodiment of the present disclosure operating in a base station as an example, Fig. 1 is a schematic diagram of a hardware structure of a base station which executes a method for determining a number of decoder iterations according to an embodiment of the present disclosure. As shown in Fig. 1, a base station 10 may include one or more (only one is shown in Fig. 1) processors 102 (the processor 102 may include, but not limited to, a processing device such as a microcontroller unit (MCU) or a field programmable gate array (FPGA)) and a storage device 104 for storing data. In some implementations, the base station 10 may further include a transmission device 106 for a communication function and an input/output device 108. It should be understood by those of ordinary skill in the art that the structure shown in Fig. 1 is merely an illustration but is not intended to limit the structure of the base station. For example, the base station 10 may include more or fewer components than those shown in Fig. 1, or may have a configuration different from that shown in Fig. 1.

The storage device 104 can be configured to store a computer program, for example, a software program or module of an application, such as a computer program corresponding to the method for determining the number of decoder iterations in the embodiment of the present disclosure. The processor 102 executes the computer program stored in the storage device 104, thereby executing variable functional applications and data processing, to implement the method described above. The storage device 104 may include a high-speed random access memory, or a non-volatile memory, such as one or more magnetic storage devices, flash memories, or other non-volatile solid-state memories. In some implementations, the storage device 104 may further include memories configured remotely with respect to the processor 102, and these remote memories may be connected to the base station 10 over a network. The examples of the network described above include, but are not limited to, the internet, intranets, local area networks, mobile communication networks, and combinations of these networks.

The transmission device 106 is configured to receive or transmit data via a network. A specific example of the above network may include a wireless network provided by a communication provider of the base station 10. In some implementations, the transmission device 106 includes a network interface controller (NIC), and the NIC may be connected to other network devices through the base station so as to communicate with the internet. In some implementations, the transmission device 106 may be a radio frequency (RF) module which is configured to communicate with the internet in a wireless manner.

Based on the base station described above, the embodiment of the present disclosure provides a method for determining a number of decoder iterations. Fig. 2 is a flowchart illustrating a method for determining a number of decoder iterations according to an embodiment of the present disclosure, and as shown in Fig. 2, the method includes the following operations:

S202, determining virtual CBs of a newly transmitted TB and a retransmitted TB to be processed by a decoder within a time slot;

S204, classifying the virtual CBs; and

S206, determining the number of iterations for each type of virtual CBs in the decoder.

Through the above operations S202 to S206, the problem of how to configure the number of the decoder iterations in the case where the capacity of the system is variable in existing art can be solved, and the number of decoder iterations is configured for the CBs of the TBs by classifying the CBs, so that the utilization rate of throughput of the decoder is improved.

In some implementations, the operation S204 may specifically include:

classifying the virtual CBs into X types, and setting a minimum limit value of the number of iterations and a maximum limit value of the number of iterations for the X types of virtual CBs, X is an integer greater than or equal to 1.

In some implementations, the operation S206 may specifically include:

determining the number of iterations for the X types of virtual CBs in the decoder according to the minimum limit value of the number of iterations and the maximum limit value of the number of iterations.

In some implementations, the operation S206 may specifically include:

S2061, determining an initial number $E_0$ of iterations for all virtual CBs;

S2062, determining a number $L_0$ of iterations for a first type of virtual CBs in the decoder according to the initial number $E_0$ of iterations, the minimum limit value of the number of iterations and the maximum limit value of the number of iterations for the first type of virtual CBs; and

S2063, determining an initial number $E_{j-1}$ of iterations for a $j$-th type of virtual CBs; determining a number $L_{j-1}$ of iterations for the $j$-th type of virtual CBs in the decoder according to the initial number $E_{j-1}$ of iterations, the minimum limit value of the number of iterations and the maximum limit value of the number of iterations for the $j$-th type of virtual CBs, $j$ is an integer greater than or equal to 2 and less than or equal to X, and the operation S2063 is repeatedly executed until the number of iterations for each of the X types of virtual CBs in the decoder is determined.

In some implementations, the operation S2061 may specifically include:

determining a number of all initial available cycles allocated for decoding within a time slot according to a working frequency of the decoder and a decoding time duration allocated by a system; and

determining a ratio of the number of all initial available cycles to a sum of numbers of cycles corresponding to single iterations of the decoder for all the virtual CBs, as the initial number $E_0$ of iterations for all virtual CBs.

In some implementations, the operation S2062 may specifically include:

comparing the maximum limit value $MAX_0$ of the number of iterations for the first type of virtual CBs with the initial number $E_0$ of iterations;

taking a smaller one from the $MAX_0$ and the $E_0$ as a value $F_0$;

comparing the $F_0$ with the minimum limit value $MIN_0$ of the number of iterations for the first type of virtual CBs; and

taking a larger one from the $F_0$ and the $MIN_0$ to obtain the number $L_0$ of iterations for the first type of virtual CBs in the decoder.

In some implementations, the operation S2063 may specifically include:

removing a sum of time durations from the time duration for the number of iterations for the first type of virtual CBs in the decoder to the time duration for the number of iterations for the $(j-1)$-th type of virtual CBs in the decoder, from an available decoding time duration allocated for decoding to obtain a residual decoding time duration, the available decoding time allocated for decoding is determined according to the number of all initial available cycles allocated for decoding within a time slot; and

determining a ratio of the residual decoding time duration to a time duration for the number of iterations for residual types of virtual CBs in the decoder, as the initial number $E_{j-1}$ of iterations for the $j$-th type of virtual CBs.

In some implementations, the operation S2063 may specifically include:

comparing the maximum limit value $MAX_{j-1}$ of the number of iterations for the $j$-th type of virtual CBs with the initial number $E_{j-1}$ of iterations for the $j$-th type of virtual CBs;

taking a smaller one from the $MAX_{j-1}$ and the $E_{j-1}$ as a value $F_{j-1}$;

comparing the $F_{j-1}$ with the minimum limit value $MIN_{j-1}$ of the number of iterations for the $j$-th type of virtual CBs; and

taking a larger one from the $F_{j-1}$ and the $MIN_{j-1}$ to obtain the number $L_{j-1}$ of iterations for the $j$-th type of virtual CBs in the decoder.

In some implementations, the operation S202 may specifically include:

performing virtualization processing on CBs of the newly transmitted TB and the retransmitted TB to obtain the virtual CBs of the newly transmitted TB and the retransmitted TB.

The TBs in the embodiment of the present disclosure include the newly transmitted TB and the retransmitted TB, and performing virtualization processing on the CBs of the newly transmitted TB and the retransmitted TB to obtain the virtual CBs of the newly transmitted TB and the retransmitted TB may specifically include:

acquiring a newly transmitted TB to be processed in a current processing time period, calculating a number of CBs contained in the newly transmitted TB, and performing virtualization processing on the number of the CBs (that is, multiplying the number of the CBs by a virtual factor) to obtain a number of virtual CBs of the newly transmitted TB; and acquiring a retransmitted TB to be processed in the current processing time period, calculating positions and a number of CBs actually to be processed for the retransmitted TB, and performing virtualization processing on the number of the CBs to obtain the number of virtual CBs of the retransmitted TB.

An embodiment of the present disclosure provides an self-adaptive method for determining a number of decoder iterations, the method can better utilize the capability of the decoder, is suitable for a bit level processing in mobile communication, and includes:

1. Performing virtualization processing on the number of CBs, including:

1) Calculating a virtualized number of newly transmitted CBs to be processed in a current processing time period, specifically including: collecting a newly transmitted TB to be processed in the current processing time period, calculating the number of CBs included in each newly transmitted TB, and multiplying the number of CBs by a virtual factor to calculate the number of virtual CBs of the newly transmitted TB (the virtualized CBs are all called virtual CBs subsequently);
2) Calculating a virtualized number of retransmitted CBs to be processed in the current processing time period, specifically including: collecting a retransmitted TB to be processed in the current processing time period to obtain positions and the number of the CBs actually to be processed for the retransmitted TB, and calculating the number of virtual CBs of the retransmitted TB according to the positions and the number of the CBs;

2. Calculating the number of iterations for each type of virtual CBs, including:

1) Classifying the virtual CBs in the current processing time period, and setting a minimum limit value of the number of iterations and a maximum limit value of the number of iterations for each type of virtual CBs;
2) Calculating an initial number of iterations for all virtual CBs, including:
calculating the initial number of iterations for all virtual CBs in the current processing time period according to a working frequency of the decoder, the number of cycles corresponding to a single iteration of the decoder for each virtual CB and a decoding time duration allocated by the system;
3) Calculating the number of iterations for the first type of virtual CBs, including:
comparing the maximum limit value of the number of iterations of the first type of virtual CBs with the initial number of iterations for all virtual CBs to take a smaller one from them as a minimum value, comparing the minimum value with the minimum limit value of the number of iterations of the first type of virtual CBs to take a larger one from them, to obtain the initial number of iterations for the first type of virtual CBs;
4) Calculating the number of iterations for the second type of virtual CBs, including:
removing a time duration for the first type of virtual CBs from an overall decoding time duration according the calculated number of iterations; calculating the number of iterations for residual types of virtual CBs according to the residual decoding time duration, the residual types of virtual CBs and corresponding parameters (a matrix size, a matrix type, an expansion factor and a number of cycles of a single iteration) of the decoder; comparing the maximum limit value of the number of iterations of a second type of virtual CBs with the initial number of iterations for the residual types of virtual CBs to take a smaller one from them as a minimum value; and comparing the minimum value with the minimum limit value of the number of iterations of the second type of virtual CBs to take a larger one from them, to obtain the number of iterations for the second type of virtual CBs;
5) Calculating the number of iterations for the third type of virtual CBs, including:
removing a time duration for the first type of virtual CBs and the second type of virtual CBs from the overall decoding time duration according to the number of iterations of the first type of virtual CBs and the number of iterations of the second type of virtual CBs, respectively; calculating an initial number of iterations for residual types of virtual CBs according to the residual decoding time duration, the residual types of virtual CBs and corresponding parameters (a matrix size, a matrix type, an expansion factor and a number of cycles of a single iteration) of the decoder; comparing the maximum limit value of the number of iterations of the third type of virtual CBs with the initial number of iterations for the residual types of virtual CBs to take a smaller one from them as a minimum value; and comparing the minimum value with the minimum limit value of the number of iterations of the third type of virtual CBs to take a larger one from them, to obtain the initial number of iterations for the third type of virtual CBs; and
6) Analogously, obtaining the number of iterations for each of the residual types of virtual CBs successively.

Specific implementations of the present disclosure are described in detail below by taking (m+n) TBs being scheduled in a time slot as an example.

Assuming that in the time slot, the number of newly transmitted TBs is m, the number of retransmitted TBs is n, and the number of all initial available cycles allocated for decoding in the time slot is S.

The numbers of cycles, caused by the TBs (including the newly transmitted TBs and the retransmitted TBs) successively, for the decoder processing a single iteration are $X_0, X_1, X_2, ..., X_{m-1}, X_m, X_{m+1}, X_{m+2}, ..., X_{m+n-1}$ respectively;

the numbers of CBs of the newly transmitted TBs are successively $C_0, C_1, ..., C_{m-1}$ respectively; and
the virtual factors of the newly transmitted TBs are successively $\alpha_0, \alpha_1, \alpha_2 ..., \alpha_{m-1}$ respectively.

As an example, the virtual factors of the newly transmitted TBs may be calculated according to a position of a time, when a first CB of each TB is started to be processed, in all initial available cycles, and assuming that the first CB of the $i$-th newly transmitted TB is started to be processed at a time $T_i$, then:

$$\alpha_i = S / (S - T_i)$$

therefore, the number of the virtual CBs of the newly transmitted TBs are successively $\alpha_0 {}^*C_0, \alpha_1 {}^*C_1, \alpha_2 {}^*C_2, ..., \alpha_{m-1} {}^*C_{m-1}$ respectively;
the number of CBs of the retransmitted TBs, which are decoded erroneously last time, are successively $O_0, O_1, O_2, ..., O_{n-1}$ respectively; and
the virtual factors of the retransmitted TBs are successively $\beta_0, \beta_1, \beta_2 ..., \beta_{n-1}$ respectively.

As an example, the virtual factors of the retransmitted TBs may be calculated according to a position of a time when a last CB of each TB, which is decoded erroneously last time, is started to be processed, in all initial available cycles, and assuming that the last CB of the $i$-th retransmitted TB, which is decoded erroneously last time, is started to be processed at a time $T_i$, then:

$$\beta_i = S / (S - T_i),$$

therefore, the numbers of the virtual CBs of the retransmitted TBs are successively $\beta_0 {}^*O_0, \beta_1 {}^*O_1, \beta_2 {}^*O_2, ..., \beta_{n-1} {}^*O_{n-1}$ respectively;
the virtual CBs may be classified into multiple types, e.g., three types:

the virtual CBs included in the newly transmitted TBs are of the first type, assuming that a range of the number of iterations for the first type of virtual CBs is $[MIN_0 : MAX_0]$;
the virtual CBs included in the TBs with a retransmitted error rate less than or equal to 10% is of the second type, assuming that the number of the TBs with the retransmitted error rate less than or equal to 10% is $p$, and assuming that a range of the number of iterations for the second type of virtual CBs is $[MIN_1 : MAX_1]$;
the virtual CBs included in the TBs with a retransmitted error rate larger than 10% is of the third type, assuming that the number of the TBs with the retransmitted error rate larger than 10% is $n-p$, and assuming that a range of the number of iterations for the third type of virtual CBs is $[MIN_2 : MAX_2]$;
calculating the initial number $E_0$ of iterations of all virtual CBs according to the following formula by using an available cycle calculation unit and a first-level iteration number calculation unit:

$$E_0 = S \left/ \left[ \sum_{i=0}^{m-1} \alpha_i * C_i * X_i + \sum_{i=0}^{n-1} \beta_i * O_i * X_{m+i} \right] \right. ,$$

using a second-level iteration number calculation unit, comparing the $MAX_0$ with the $E_0$ to take a smaller one from them as a minimum value $F_0$, and comparing the $F_0$ with the $MIN_0$ to take a larger one from them, to obtain the number $L_0$ of iterations for the first type of virtual CBs in the decoder;
calculating the initial number $E_1$ of iterations of the second type of virtual CBs according to the following formula by continuously using the available cycle calculation unit and the first-level iteration number calculation unit:

$$E_1 = \left[ S - \sum_{i=0}^{m-1} \alpha_i * C_i * X_i * L_0 \right] \left/ \left[ \sum_{i=0}^{n-1} \beta_i * O_i * X_{m+i} \right] \right. ,$$

continuously using the second-level iteration number calculation unit, comparing the $MAX_1$ with the $E_1$ to take a smaller one from them as a minimum value $F_1$, and comparing the $F_1$ with the $MIN_1$ to take a larger one from them, to obtain the number $L_1$ of iterations for the second type of virtual CBs in the decoder;

calculating the initial number $E_2$ of iterations of the third type of virtual CBs according to the following formula by continuously using the available cycle calculation unit and the first-level iteration number calculation unit:

$$E_2 = \frac{S - \sum_{i=0}^{m-1} \alpha_i * C_i * X_i * L_0 - \sum_{i=0}^{p-1} \beta_i * O_i * X_{m+i} * L_1}{\sum_{i=p}^{n-1} \beta_i * O_i * X_{m+i}} \quad ,$$

continuously using the second-level iteration number calculation unit, comparing the $MAX_2$ with the $E_2$ to take a smaller one from them as a minimum value $F_2$, and comparing the $F_2$ with the $MIN_2$ to take a larger one from them, to obtain the number $L_2$ of iterations for the third type of virtual CBs in the decoder;

executing parallel decoding or serial decoding according to the number of iterations configured for each CB, until all the CBs in the current time slot are decoded.

Through the embodiment of the present disclosure, adopting the method of classifying and calculating the number of iterations of the CBs after performing virtualization processing on the CBs of each TB, the number of decoder iterations can be self-adaptively configured for the TBs, so that the utilization rate of throughput of the decoder is greatly improved, and the performance of the whole mobile communication system is improved.

It should be understood that the above-described method for calculating the virtual factors is only presented as an example, and actually, the virtual factors may be calculated or configured by other methods as required. For example, for retransmitted TBs, the virtual factor may also be calculated according to a position of a time when the second-last CB of each TB or any CB of each TB, which is decoded erroneously, is started to be processed, in all initial available cycles at the time. In summary, the available processing time duration for each TB is the whole time slot in principle, however, the processing time duration actually used by each TB is not the whole time slot. Therefore, for each newly transmitted or retransmitted TB, the virtual factor of the TB can be reasonably calculated or configured in consideration of a proportion of the time duration, actually occupied by the CBs to be decoded in the TB, in the whole time slot, so that the capability of the decoder can be utilized better.

Through the description of the above embodiment, it is clear to those skilled in the art that the method according to the above embodiment may be implemented by software plus a common hardware platform, and certainly may also be implemented by hardware only, but the former is a better implementation in many cases. Based on the above understanding, the technical solutions of the present disclosure in essence or a part thereof contributing to the existing art may be embodied in the form of a product of computer software , the product of computer software may be stored in a storage medium (such as a Read-Only Memory (ROM)/Random Access Memory (RAM), a magnetic disk, and an optical disk), and includes several computer-readable instructions for enabling a terminal device (may be a mobile phone, a computer, a server, or a network device and the like) to execute the method in the embodiment of the present disclosure.

The present disclosure further provides a device for determining a number of decoder iterations, and the device is configured to implement the above embodiment and implementations, and details of which have been already described and thus are not repeated here. As used below, the term "module" may be a combination of software and/or hardware with a preset functionality. Although the device described below is better when being implemented in software, the implementations in hardware or a combination of software and hardware are also possible and contemplated.

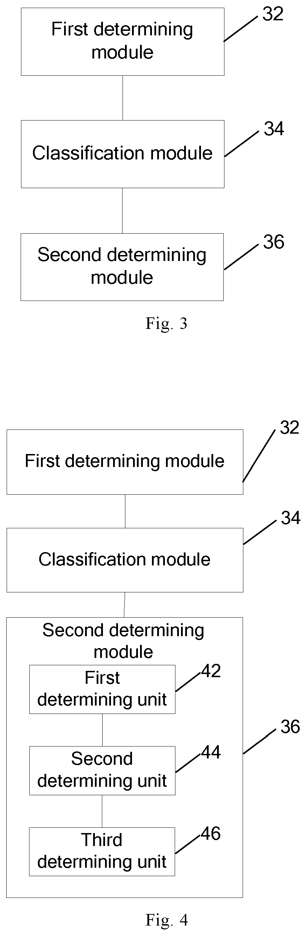

Fig. 3 is a schematic diagram of a device for determining a number of decoder iterations according to the present disclosure, as shown in Fig. 3, the device for determining the number of decoder iterations includes:

a first determining module 32 configured to determine virtual CBs of a newly transmitted TB and a retransmitted TB to be processed by a decoder within a time slot;
a classification module 34 configured to classify the virtual CBs; and
a second determining module 36 configured to determine the number of iterations for each type of virtual CBs in the decoder.

In some implementations, the classification module 34 is further configured to:
classify the virtual CBs into X types, and setting a minimum limit value of the number of iterations and a maximum limit value of the number of iterations for the X types of virtual CBs, X is an integer greater than or equal to 1.

In some implementations, the second determining module 36 is further configured to:
determine the number of iterations for the X types of virtual CBs in the decoder according to the minimum limit value of the number of iterations and the maximum limit value of the number of iterations.

Fig. 4 is a schematic diagram of an example of a device for determining a number of decoder iterations according to the present disclosure, as shown in Fig. 4, the second determining module 36 includes:

a first determining unit 42 configured to determine an initial number $E_0$ of iterations for all virtual CBs;

a second determining unit 44 configured to determine a number $L_0$ of iterations for a first type of virtual CBs in the decoder according to the initial number $E_0$ of iterations, the minimum limit value of the number of iterations and the maximum limit value of the number of iterations for the first type of virtual CBs; and

a third determining unit 46 configured to determine an initial number $E_{j-1}$ of iterations for a $j$-th type of virtual CBs; determining a number $L_{j-1}$ of iterations for the $j$-th type of virtual CBs in the decoder according to the initial number $E_{j-1}$ of iterations, the minimum limit value of the number of iterations and the maximum limit value of the number of iterations for the $j$-th type of virtual CBs, $j$ is an integer greater than or equal to 2 and less than or equal to X, and $j$ may increase from $j=2$, until the number of iterations for each of the X types of virtual CBs in the decoder is determined.

In some implementations, the first determining unit 42 is further configured to:

determine the number of all initial available cycles allocated for decoding within a time slot according to a working frequency of the decoder and a decoding time duration allocated by a system; and

determine a ratio of the number of all initial available cycles to a sum of numbers of cycles corresponding to single iterations of the decoder for all virtual CBs, as the initial number $E_0$ of iterations for all virtual CBs.

In some implementations, the second determining unit 44 is further configured to:

compare the maximum limit value $MAX_0$ of the number of iterations for the first type of virtual CBs with the initial number $E_0$ of iterations;

take the $MAX_0$ and the $E_0$ as a minimum value $F_0$ ;

compare the $F_0$ with the minimum limit value $MIN_0$ of the number of iterations for the first type of virtual CBs; and

take a larger one from the $F_0$ and the $MIN_0$ to obtain the number $L_0$ of iterations for the first type of virtual CBs in the decoder.

In some implementations, the third determining unit 46 is further configured to:

remove a sum of time durations, from the time duration for the number of iterations for the first type of virtual CBs in the decoder to the time duration for the number of iterations for the ($j$-1)-th type of virtual CBs in the decoder, from the available decoding time duration allocated for decoding, to obtain a residual decoding time duration, the available decoding time duration allocated for decoding is determined according to the number of all initial available cycles allocated for decoding within a time slot; and

determine a ratio of the residual decoding time duration to a sum of time durations for the number of iterations for the residual types of virtual CBs in the decoder, as the initial number $E_{j-1}$ of iterations for the $j$-th type of virtual CBs.

In some implementations, the third determining unit 46 is further configured to:

compare the maximum limit value $MAX_{j-1}$ of the number of iterations for the $j$-th type of virtual CBs with the initial number $E_{j-1}$ of iterations for the $j$-th type of virtual CBs;

take a smaller one from the $MAX_{j-1}$ and the $E_{j-1}$ as a minimum value $F_{j-1}$;

compare the $F_{j-1}$ with the minimum limit value $MIN_{j-1}$ of the number of iterations for the $j$-th type of virtual CBs; and

taking a larger one from the $F_{j-1}$ and the $MIN_{j-1}$ to obtain the number $L_{j-1}$ of iterations for the $j$-th type of virtual CBs in the decoder.

In some implementations, the first determining module 32 is further configured to:
perform virtualization processing on the CBs of the newly transmitted TB and the retransmitted TB to obtain the virtual CBs of the newly transmitted TB and the retransmitted TB.

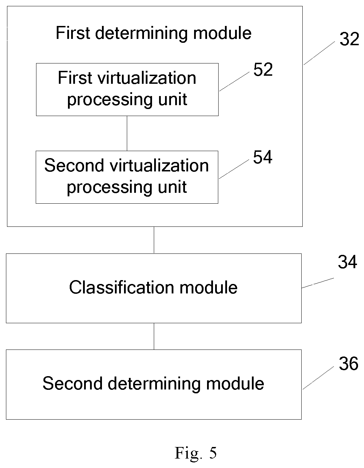

Fig. 5 is a schematic diagram of another example of a device for determining a number of decoder iterations according to the present disclosure, as shown in Fig. 5, the first determining module 32 includes:

a first virtualization processing unit 52 configured to acquire a newly transmitted TB to be processed in a current processing time period, calculating the number of CBs contained in the newly transmitted TB, and performing virtualization processing on the number of the CBs to obtain the number of virtual CBs of the newly transmitted TB; and

a first virtualization processing unit 54 configured to acquire a retransmitted TB to be processed in the current processing time period, calculating a position and the number of the CBs actually to be processed for the retransmitted TB, and performing virtualization processing on the number of the CBs to obtain the number of virtual CBs of the retransmitted TB.

It should be noted that the above modules may be implemented by software or hardware, and for the hardware, the following manners may be implemented, but are not limited: the modules may be all located in a same processor; alternatively, the modules may be located in different processors in any combination.

An embodiment of the present disclosure further provides a storage medium having a computer program stored therein, the computer programs, when executed, perform the method in the embodiment of the present disclosure described above.

In some implementations, the storage medium may be configured to store a computer program for performing following operations S11 to S13:

S11, determining virtual CBs of a newly transmitted TB and a retransmitted TB to be processed by a decoder within a time slot;

S12, classifying the virtual CBs; and

S13, determining the number of iterations for each type of virtual CBs in the decoder.

In some implementations, the storage medium may include, but is not limited to: any other medium which can be used to store the computer programs, such as a Universal Serial Bus (USB) disk, a ROM, a RAM, a mobile hard disk, a magnetic disk, or an optical disk and the like.

An embodiment of the present disclosure further provides an electronic device, including a processor and a memory, the memory having a computer program stored therein, and the processor is configured to execute the computer program, so as to perform the method in the embodiment of the present disclosure described above.

In some implementations, the electronic device may further include a transmission device and an input/output device, the transmission device is connected to the processor described above, and the input/output device is connected to the processor described above.

In some implementations, the processor described above may be configured to perform following operations S11 to S13 through the computer program:

S11, determining virtual CBs of a newly transmitted TB and a retransmitted TB to be processed by a decoder within a time slot;

S12, classifying the virtual CBs; and

S13, determining the number of iterations for each type of virtual CBs in the decoder.

The specific examples of the embodiment may be referred to the examples of the embodiment described above, and thus are not repeated here.

Obviously, it should be understood by those skilled in the art that, the above modules or operations of the present disclosure may be implemented by a universal computing device, they may be centralized on a single computing device or distributed on a network composed of multiple computing devices, alternatively, they may be implemented by application codes being executable by a computing device, and therefore, they may be stored in a storage device and executed by the computing device, and in some cases, the operations shown or described may be executed out of the order in the embodiment of the present disclosure, or they may be implemented by respectively fabricating them into integrated circuit modules, or by fabricating a plurality of modules or operations of them into a single integrated circuit module. The present disclosure is not limited to any specific combination of hardware and software.

The above description is only for describing some embodiments of the present disclosure, but is not to limit the present disclosure, and for those skilled in the art, variable modifications and changes may be made without departing from the present disclosure. Any modification, equivalent substitution, improvement and the like made within the principle of the present disclosure should be considered to be included in the present disclosure. The scope of protection is defined only by the appended claims.

**Claims**

1. A method for determining a number of decoder iterations in a 4G or 5G mobile communication system, comprising:

determining virtual code blocks of a newly transmitted transport block and a retransmitted transport block to be processed by a decoder within a time slot;

classifying the virtual code blocks according to whether the transport block corresponding to the virtual code block is the newly transmitted transport block, or, according to a retransmitted error rate of the retransmitted transport block; and

determining the number of iterations for each type of virtual code blocks in the decoder;

wherein, the determining virtual code blocks of a newly transmitted transport block and a retransmitted transport block to be processed by a decoder within a time slot comprises:

calculating the number of code blocks contained in the newly transmitted transport block, and multiplying the number of code blocks, contained in the newly transmitted transport block, by a first virtual factor to obtain the number of virtual code blocks of the newly transmitted transport block, the first virtual factor is calculated or configured based on a proportion of a time duration, actually occupied by the code blocks to be decoded in the newly transmitted transport block, in the time slot; and

calculating positions and the number of code blocks actually to be processed for the retransmitted transport block, and multiplying the number of code blocks, actually to be processed for the retransmitted transport block, by a second virtual factor to obtain the number of virtual code blocks of the retransmitted transport block, the second virtual factor is calculated or configured base on a proportion of a time duration, actually occupied by the code blocks actually to be processed for the retransmitted transport block, in the time slot, the code blocks actually to be processed for the retransmitted transport block are code blocks which were previously decoded erroneously.

2. The method of claim 1, wherein the classifying the virtual code blocks comprises:

classifying the virtual code blocks into X types, and setting a minimum limit value of the number of iterations and a maximum limit value of the number of iterations for the X types of virtual code blocks, wherein X is an integer greater than or equal to 1.

3. The method of claim 2, wherein the determining the number of iterations for each type of virtual code blocks in the decoder comprises:

determining the number of iterations for the X types of virtual code blocks in the decoder according to the minimum limit value of the number of iterations and the maximum limit value of the number of iterations.

4. The method of claim 3, wherein the determining the number of iterations for the X types of virtual code blocks in the decoder according to the minimum limit value of the number of iterations and the maximum limit value of the number of iterations comprises:

determining an initial number $E_0$ of iterations for all virtual code blocks;

determining a number $L_0$ of iterations for a first type of virtual code blocks in the decoder according to the initial number $E_0$ of iterations, the minimum limit value of the number of iterations and the maximum limit value of the number of iterations for the first type of virtual code blocks; and

determining an initial number $E_{j-1}$ of iterations for a $j$-th type of virtual code blocks; determining a number $L_{j-1}$ of iterations for the $j$-th type of virtual code blocks in the decoder according to the initial number $E_{j-1}$ of iterations, the minimum limit value of the number of iterations and the maximum limit value of the number of iterations for the $j$-th type of virtual code blocks, wherein $j$ is an integer greater than or equal to 2 and less than or equal to X.

5. The method of claim 4, wherein the determining the initial number $E_0$ of iterations for all virtual code blocks comprises:

determining a number of all initial available cycles allocated for decoding within a time slot according to a working frequency of the decoder and a decoding time duration allocated by the 4G or 5G mobile communication system; and

determining a ratio of the number of all initial available cycles to a sum of numbers of cycles corresponding to single iterations of the decoder for all virtual code blocks, as the initial number $E_0$ of iterations for all virtual code blocks.

6. The method of claim 4, wherein the determining the number $L_0$ of iterations for the first type of virtual code blocks in the decoder according to the initial number $E_0$ of iterations, the minimum limit value of the number of iterations and the maximum limit value of the number of iterations for the first type of virtual code blocks comprises:

comparing the maximum limit value $MAX_0$ of the number of iterations for the first type of virtual code blocks with the initial number $E_0$ of iterations;

taking a smaller one from the $MAX_0$ and the $E_0$ as a minimum value $F_0$;

comparing the $F_0$ with the minimum limit value $MIN_0$ of the number of iterations for the first type of virtual code blocks; and

taking a larger one from the $F_0$ and the $MIN_0$ to obtain the number $L_0$ of iterations for the first type of virtual code blocks in the decoder.

7. The method of claim 4, wherein the determining the initial number $E_{j-1}$ of iterations for the $j$-th type of virtual code blocks comprises:

subtracting a sum of time durations, comprising time durations for the number of iterations for the first type of virtual code blocks up to the ($j$-1)-th type of virtual code blocks in the decoder, from an available decoding time duration allocated for decoding to obtain a residual decoding time duration, wherein the available decoding time duration allocated for decoding is determined according to the number of all initial available cycles allocated for decoding within a time slot; and

determining a ratio of the residual decoding time duration to a sum of time durations for the number of iterations for each of the residual types of virtual code blocks in the decoder, as the initial number $E_{j-1}$ of iterations for the $j$-th type of virtual code blocks.

8. The method of claim 4, wherein the determining the number $L_{j-1}$ of iterations for the $j$-th type of virtual code blocks in the decoder according to the initial number $E_{j-1}$ of iterations, the minimum limit value of the number of iterations and the maximum limit value of the number of iterations for the $j$-th type of virtual code blocks comprises:

comparing the maximum limit value $MAX_{j-1}$ of the number of iterations for the $j$-th type of virtual code blocks with the initial number $E_{j-1}$ of iterations for the $j$-th type of virtual code blocks;

taking a smaller one from the $MAX_{j-1}$ and the $E_{j-1}$ as a minimum value $F_{j-1}$;

comparing the $F_{j-1}$ with the minimum limit value $MIN_{j-1}$ of the number of iterations for the $j$-th type of virtual code blocks; and

taking a larger one from the $F_{j-1}$ and the $MIN_{j-1}$ to obtain the number $L_{j-1}$ of iterations for the $j$-th type of virtual code blocks in the decoder.

9. A storage medium having a computer program stored therein, the computer program, when executed by a processor, performs the method of any one of claims 1 to 8.

10. An electronic device, comprising a processor and a memory;

the memory having a computer program stored therein; and

the processor is configured to execute the computer program, so as to perform the method of any one of claims 1 to 8.

**Patentansprüche**

1. Verfahren zum Bestimmen einer Anzahl von Decodierwiederholungen in einem 4G- oder 5G-Mobilkommunikationssystem, umfassend:

Bestimmen von virtuellen Codeblöcken eines neu übertragenen Transportblocks und eines erneut übertragenen Transportblocks, die von einem Decodierer innerhalb eines Zeitfensters zu verarbeiten sind;

Klassifizieren der virtuellen Codeblöcke in Abhängigkeit davon, ob der Transportblock, der dem virtuellen Codeblock entspricht, der neu übertragene Transportblock ist, oder

in Abhängigkeit von einer erneut übertragenen Fehlerrate des erneut übertragenen Transportblocks; und

Bestimmen der Anzahl von Wiederholungen für jeden Typ von virtuellen Codeblöcken in dem Decodierer;

wobei das Bestimmen von virtuellen Codeblöcken eines neu übertragenen Transportblocks und eines erneut übertragenen Transportblocks, die von einem Decodierer innerhalb eines Zeitfensters zu verarbeiten sind, umfasst:

Berechnen der Anzahl von Codeblöcken, die in dem neu übertragenen Transportblock enthalten sind, und Multiplizieren der Anzahl von Codeblöcken, die in dem neu übertragenen Transportblock enthalten sind, mit einem ersten virtuellen Faktor, um die Anzahl von virtuellen Codeblöcken des neu übertragenen Transportblocks zu erhalten, wobei der erste virtuelle Faktor auf Basis eines Anteils einer Zeitdauer, die tatsächlich von den Codeblöcken belegt ist, die in dem neu übertragenen Transportblock zu decodieren sind, in dem Zeitfenster berechnet oder konfiguriert wird; und

Berechnen von Positionen und der Anzahl von Codeblöcken, die tatsächlich für den erneut übertragenen Transportblock zu verarbeiten sind, und Multiplizieren der Anzahl von Codeblöcken, die tatsächlich für den erneut übertragenen Transportblock zu verarbeiten sind, mit einem zweiten virtuellen Faktor, um die Anzahl von virtuellen Codeblöcken des erneut übertragenen Transportblocks zu erhalten, wobei der zweite virtuelle Faktor auf Basis eines Anteils einer Zeitdauer, die tatsächlich von den Codeblöcken belegt ist, die tatsächlich für den erneut übertragenen Transportblock zu verarbeiten sind, in dem Zeitfenster berechnet oder konfiguriert wird,

wobei die Codeblöcke, die tatsächlich für den erneut übertragenen Transportblock zu verarbeiten sind, Codeblöcke sind, die zuvor fehlerhaft decodiert wurden.

2. Verfahren nach Anspruch 1, wobei das Klassifizieren der virtuellen Codeblöcke umfasst:
Klassifizieren der virtuellen Codeblöcke in X Typen und Einstellen eines minimalen Grenzwerts der Anzahl von Wiederholungen und eines maximalen Grenzwerts der Anzahl von Wiederholungen für die X Typen von virtuellen Codeblöcken, wobei X eine ganze Zahl größer oder gleich 1 ist.

3. Verfahren nach Anspruch 2, wobei das Bestimmen der Anzahl von Wiederholungen für jeden Typ von virtuellen Codeblöcken in dem Decodierer umfasst:
Bestimmen der Anzahl von Wiederholungen für die X Typen von virtuellen Codeblöcken in dem Decodierer gemäß dem minimalen Grenzwert der Anzahl von Wiederholungen und dem maximalen Grenzwert der Anzahl von Wiederholungen.

4. Verfahren nach Anspruch 3, wobei das Bestimmen der Anzahl von Wiederholungen für die X Typen von virtuellen Codeblöcken in dem Decodierer gemäß dem minimalen Grenzwert der Anzahl von Wiederholungen und dem maximalen Grenzwert der Anzahl von Wiederholungen umfasst:

Bestimmen einer Anfangsanzahl $E_0$ von Wiederholungen für alle virtuellen Codeblöcke;
Bestimmen einer Anzahl $L_0$ von Wiederholungen für einen ersten Typ von virtuellen Codeblöcken in dem Decodierer gemäß der Anfangsanzahl $E_0$ von Wiederholungen, dem minimalen Grenzwert der Anzahl von Wiederholungen und dem maximalen Grenzwert der Anzahl von Wiederholungen für den ersten Typ von virtuellen Codeblöcken; und
Bestimmen einer Anfangsanzahl $E_{j-1}$ von Wiederholungen für einen $j$-ten Typ von virtuellen Codeblöcken;
Bestimmen einer Anzahl $L_{j-1}$ von Wiederholungen für den $j$-ten Typ von virtuellen Codeblöcken in dem Decodierer gemäß der Anfangsanzahl $E_{j-1}$ von Wiederholungen, dem minimalen Grenzwert der Anzahl von Wiederholungen und dem maximalen Grenzwert der Anzahl von Wiederholungen für den $j$-ten Typ von virtuellen Codeblöcken, wobei $j$ eine ganze Zahl größer oder gleich 2 und kleiner oder gleich X ist.

5. Verfahren nach Anspruch 4, wobei das Bestimmen der Anfangsanzahl $E_0$ von Wiederholungen für alle virtuellen Codeblöcke umfasst:

Bestimmen einer Anzahl aller anfänglich verfügbaren Zyklen, die zum Decodieren innerhalb eines Zeitfensters zugewiesen sind, gemäß einer Arbeitsfrequenz des Decodierers und einer Decodierzeitdauer, die durch das 4G- oder 5G-Mobilkommunikationssystem zugewiesen ist; und
Bestimmen eines Verhältnisses der Anzahl aller anfänglich verfügbaren Zyklen zu einer Summe von Anzahlen von Zyklen, die einzelnen Wiederholungen des Decodierers für alle virtuellen Codeblöcke entsprechen, als die Anfangsanzahl $E_0$ von Wiederholungen für alle virtuellen Codeblöcke.

6. Verfahren nach Anspruch 4, wobei das Bestimmen der Anzahl $L_0$ von Wiederholungen für den ersten Typ von virtuellen Codeblöcken in dem Decodierer gemäß der Anfangsanzahl $E_0$ von Wiederholungen, dem minimalen Grenzwert der Anzahl von Wiederholungen und dem maximalen Grenzwert der Anzahl von Wiederholungen für den ersten Typ von virtuellen Codeblöcken umfasst:

Vergleichen des maximalen Grenzwerts $MAX_0$ der Anzahl von Wiederholungen für den ersten Typ von virtuellen Codeblöcken mit der Anfangsanzahl $E_0$ von Wiederholungen;
Nehmen eines kleineren aus dem $MAX_0$ und dem $E_0$ als einen minimalen Wert $F_0$;

Vergleichen des $F_0$ mit dem minimalen Grenzwert $MIN_0$ der Anzahl von Wiederholungen für den ersten Typ von virtuellen Codeblöcken; und

Nehmen eines größeren aus dem $F_0$ und dem $MIN_0$, um die Anzahl $L_0$ von Wiederholungen für den ersten Typ von virtuellen Codeblöcken in dem Decodierer zu erhalten.

**7.** Verfahren nach Anspruch 4, wobei das Bestimmen der Anfangsanzahl $E_{j-1}$ von Wiederholungen für den $j$-ten Typ von virtuellen Codeblöcken umfasst:

Subtrahieren einer Summe von Zeitdauern, die Zeitdauern für die Anzahl von Wiederholungen für den ersten Typ von virtuellen Codeblöcken bis zu dem (j-1)-ten Typ von virtuellen Codeblöcken in dem Decodierer umfasst, von einer verfügbaren Decodierzeitdauer, die zum Decodieren zugewiesen ist, um eine Restdecodierzeitdauer zu erhalten, wobei die verfügbare Decodierzeitdauer, die zum Decodieren zugewiesen ist, gemäß der Anzahl aller anfänglich verfügbaren Zyklen bestimmt wird, die zum Decodieren innerhalb eines Zeitfensters zugewiesen sind; und

Bestimmen eines Verhältnisses der Restdecodierzeitdauer zu einer Summe von Zeitdauern für die Anzahl von Wiederholungen für jeden der Resttypen von virtuellen Codeblöcken in dem Decodierer als die Anfangsanzahl $E_{j-1}$ von Wiederholungen für den $j$-ten Typ von virtuellen Codeblöcken.

**8.** Verfahren nach Anspruch 4, wobei das Bestimmen der Anzahl $L_{j-1}$ von Wiederholungen für den $j$-ten Typ von virtuellen Codeblöcken in dem Decodierer gemäß der Anfangsanzahl $E_{j-1}$ von Wiederholungen, dem minimalen Grenzwert der Anzahl von Wiederholungen und dem maximalen Grenzwert der Anzahl von Wiederholungen für den $j$-ten Typ von virtuellen Codeblöcken umfasst:

Vergleichen des maximalen Grenzwerts $MAX_{j-1}$ der Anzahl von Wiederholungen für den $j$-ten Typ von virtuellen Codeblöcken mit der Anfangsanzahl $E_{j-1}$ von Wiederholungen für den $j$-ten Typ von virtuellen Codeblöcken;

Nehmen eines kleineren aus dem $MAX_{j-1}$ und dem $E_{j-1}$ als einen minimalen Wert $F_{j-1}$;

Vergleichen des $F_{j-1}$ mit dem minimalen Grenzwert $MIN_{j-1}$ der Anzahl von Wiederholungen für den $j$-ten Typ von virtuellen Codeblöcken; und

Nehmen eines größeren aus dem $F_{j-1}$ und dem $MIN_{j-1}$, um die Anzahl $L_{j-1}$ von Wiederholungen für den $j$-ten Typ von virtuellen Codeblöcken in dem Decodierer zu erhalten.

**9.** Speichermedium mit einem darin gespeicherten Computerprogramm, wobei das Computerprogramm, wenn es von einem Prozessor ausgeführt wird, das Verfahren nach einem der Ansprüche 1 bis 8 durchführt.

**10.** Elektronisches Gerät, umfassend einen Prozessor und einen Speicher;

wobei der Speicher ein darin gespeichertes Computerprogramm aufweist; und

der Prozessor zum Ausführen des Computerprogramms konfiguriert ist, um das Verfahren nach einem der Ansprüche 1 bis 8 durchzuführen.

**Revendications**

**1.** Procédé pour déterminer un nombre d'itérations de décodeur dans un système de communication mobile 4G ou 5G, comprenant les étapes consistant à :

déterminer des blocs de code virtuels d'un bloc de transport nouvellement envoyé et d'un bloc de transport réenvoyé à traiter par un décodeur dans un créneau temporel ;

classer les blocs de code virtuels selon que le bloc de transport correspondant au bloc de code virtuel est le bloc de transport nouvellement envoyé, ou

selon un taux d'erreur réenvoyé du bloc de transport réenvoyé ; et

déterminer le nombre d'itérations pour chaque type de blocs de code virtuels dans le décodeur ;

dans lequel déterminer des blocs de code virtuels d'un bloc de transport nouvellement envoyé et d'un bloc de transport réenvoyé à traiter par un décodeur dans un créneau temporel comprend les étapes consistant à :

calculer le nombre de blocs de code contenus dans le bloc de transport nouvellement envoyé, et multiplier le nombre de blocs de code, contenus dans le bloc de transport nouvellement envoyé, par un premier facteur virtuel pour obtenir le nombre de blocs de code virtuels du bloc de transport nouvellement envoyé, le premier facteur virtuel étant calculé ou configuré sur la base d'une proportion d'une durée, réellement occupée par les blocs de code à décoder dans le bloc de transport nouvellement envoyé, dans le créneau temporel ; et calculer des positions et le nombre de blocs de code réellement à traiter pour le bloc de transport réenvoyé, et multiplier le nombre de blocs de code, réellement à traiter pour le bloc de transport réenvoyé, par un second facteur virtuel pour obtenir le nombre de blocs de code virtuels du bloc de transport réenvoyé, le second facteur virtuel étant calculé ou configuré sur la base d'une proportion d'une durée, réellement occupée par les blocs de code réellement à traiter pour le bloc de transport réenvoyé, dans le créneau temporel,
les blocs de code réellement à traiter pour le bloc de transport réenvoyé étant des blocs de code qui ont été précédemment décodés par erreur.

2. Procédé selon la revendication 1, dans lequel classer les blocs de code virtuels comprend les étapes consistant à :
classer les blocs de code virtuels en X types, et définir une valeur limite minimale du nombre d'itérations et une valeur limite maximale du nombre d'itérations pour les X types de blocs de code virtuels, X étant un entier supérieur ou égal à 1.

3. Procédé selon la revendication 2, dans lequel déterminer le nombre d'itérations pour chaque type de blocs de code virtuels dans le décodeur comprend les étapes consistant à :
déterminer le nombre d'itérations pour les X types de blocs de code virtuels dans le décodeur en fonction de la valeur limite minimale du nombre d'itérations et de la valeur limite maximale du nombre d'itérations.

4. Procédé selon la revendication 3, dans lequel déterminer le nombre d'itérations pour les X types de blocs de code virtuels dans le décodeur en fonction de la valeur limite minimale du nombre d'itérations et de la valeur limite maximale du nombre d'itérations comprend les étapes consistant à :

déterminer un nombre initial $E_0$ d'itérations pour tous les blocs de code virtuels ;
déterminer un nombre $L_0$ d'itérations pour un premier type de blocs de code virtuels dans le décodeur en fonction du nombre initial $E_0$ d'itérations, de la valeur limite minimale du nombre d'itérations et de la valeur limite maximale du nombre d'itérations pour le premier type de blocs de code virtuels ; et
déterminer un nombre initial $E_{j-1}$ d'itérations pour un $j$-ième type de blocs de code virtuel ; déterminer un nombre $L_{j-1}$ d'itérations pour le $j$-ième type de blocs de code virtuels dans le décodeur en fonction du nombre initial $E_{j-1}$ d'itérations, de la valeur limite minimale du nombre d'itérations et de la valeur limite maximale du nombre d'itérations pour le $j$-ième type de blocs de code virtuels, $j$ étant un entier supérieur ou égal à 2 et inférieur ou égal à X.

5. Procédé selon la revendication 4, dans lequel déterminer le nombre initial $E_0$ d'itérations pour tous les blocs de code virtuels comprend les étapes consistant à :

déterminer un nombre de tous les cycles disponibles initiaux attribués pour décoder dans un créneau temporel en fonction d'une fréquence de travail du décodeur et d'une durée de temps de décodage attribuée par le système de communication mobile 4G ou 5G ; et
déterminer un ratio du nombre de tous les cycles disponibles initiaux sur une somme de nombres de cycles correspondant à des itérations individuelles du décodeur pour tous les blocs de code virtuels, en tant que nombre initial $E_0$ d'itérations pour tous les blocs de code virtuels.

6. Procédé selon la revendication 4, dans lequel déterminer le nombre $L_0$ d'itérations pour le premier type de blocs de code virtuels dans le décodeur en fonction du nombre initial $E_0$ d'itérations, de la valeur limite minimale du nombre d'itérations et de la valeur limite maximale du nombre d'itérations pour le premier type de blocs de code virtuels comprend les étapes consistant à :

comparer la valeur limite maximale $MAX_0$ du nombre d'itérations pour le premier type de blocs de code virtuels avec le nombre initial $E_0$ d'itérations ;
prendre une valeur plus petite parmi $MAX_0$ et $E_0$ en tant que valeur minimale $F_0$ ;
comparer $F_0$ avec la valeur limite minimale $MIN_0$ du nombre d'itérations pour le premier type de blocs de code virtuels ; et
prendre une valeur plus grande parmi $F_0$ et $MIN_0$ pour obtenir le nombre $L_0$ d'itérations pour le premier type de blocs de code virtuels dans le décodeur.

7. Procédé selon la revendication 4, dans lequel déterminer le nombre initial $E_{j-1}$ d'itérations pour le $j$-ième type de blocs de code virtuels comprend les étapes consistant à :

soustraire une somme de durées, comprenant des durées pour le nombre d'itérations pour le premier type de blocs de code virtuels jusqu'au (j-1)-ième type de blocs de code virtuels dans le décodeur, d'une durée de temps de décodage disponible attribuée pour décoder pour obtenir une durée de temps de décodage résiduelle, dans lequel la durée de temps de décodage disponible attribuée pour décoder est déterminée en fonction du nombre de tous les cycles disponibles initiaux attribués pour décoder dans un créneau temporel ; et

déterminer un ratio de la durée de temps de décodage résiduelle sur une somme de durées pour le nombre d'itérations pour chacun des types résiduels de blocs de code virtuels dans le décodeur, en tant que nombre initial $E_{j-1}$ d'itérations pour le $j$-ième type de blocs de code virtuels.

8. Procédé selon la revendication 4, dans lequel déterminer le nombre $L_{j-1}$ d'itérations pour le $j$-ième type de blocs de code virtuels dans le décodeur en fonction du nombre initial $E_{j-1}$ d'itérations, de la valeur limite minimale du nombre d'itérations et de la valeur limite maximale du nombre d'itérations pour le $j$-ième type de blocs de code virtuels comprend les étapes consistant à :

comparer la valeur limite maximale $MAX_{j-1}$ du nombre d'itérations pour le $j$-ième type de blocs de code virtuels avec le nombre initial $E_{j-1}$ d'itérations pour le $j$-ième type de blocs de code virtuels ;

prendre une valeur plus petite parmi $MAX_{j-1}$ et $E_{j-1}$ en tant que valeur minimale $F_{j-1}$ ;

comparer $F_{j-1}$ avec la valeur limite minimale $MIN_{j-1}$ du nombre d'itérations pour le $j$-ième type de blocs de code virtuels ; et

prendre une valeur plus grande parmi $F_{j-1}$ et $MIN_{j-1}$ pour obtenir le nombre $L_{j-1}$ d'itérations pour le $j$-ième type de blocs de code virtuels dans le décodeur.

9. Moyen de stockage sur lequel est stocké un programme informatique, le programme informatique, lorsqu'il est exécuté par un processeur, réalise le procédé selon l'une quelconque des revendications 1 à 8.

10. Dispositif électronique, comprenant un processeur et une mémoire ;

la mémoire sur laquelle est stocké un programme informatique ; et

le processeur est configuré pour exécuter le programme informatique, de manière à réaliser le procédé selon l'une quelconque des revendications 1 à 8.

Input/Output decice
108

Transmission
device
106

Processor 102

Storage
device 104

Fig. 1

determining virtual code blocks (CBs) of a newly transmitted transport block (TB) and a retransmitted TB to be processed by a decoder within a time slot

S202

classifying the virtual CBs

S204

determining the number of iterations for each type of virtual CBs in the decoder

S206

Fig. 2

First determining
module — 32

Classification module — 34

Second determining
module — 36

Fig. 3

First determining module — 32

Classification module — 34

Second determining
module

First
determining unit — 42

Second
determining unit — 44

Third
determining unit — 46

— 36

Fig. 4

First determining module — 32

First virtualization processing unit — 52

Second virtualization processing unit — 54

Classification module — 34

Second determining module — 36

Fig. 5

**EP 3 979 505 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2014247909 A1
- US 2014269627 A1
- EP 2249503 A1
- US 10020825 B1